(19) **Europäisches Patentamt European Patent Office Office européen des brevets**

(11) **EP 2 856 188 B1**

(12) **FASCICULE DE BREVET EUROPEEN**

(45) Date de publication et mention
de la délivrance du brevet:
**01.05.2019 Bulletin 2019/18**

(51) Int Cl.:
***G01R 31/36*** *(2019.01)*       ***H01M 10/48*** *(2006.01)*
***B60L 11/18*** *(2006.01)*

(21) Numéro de dépôt: **13725355.5**

(22) Date de dépôt: **24.05.2013**

(86) Numéro de dépôt international:
**PCT/EP2013/060798**

(87) Numéro de publication internationale:
**WO 2013/175006 (28.11.2013 Gazette 2013/48)**

(54) **PROCEDE DE DETERMINATION D'UN ETAT D'ENERGIE D'UN ACCUMULATEUR ELECTROCHIMIQUE, DISPOSITIF, SUPPORT ET PROGRAMME INFORMATIQUE**

VERFAHREN ZUR BESTIMMUNG EINES VERSORGUNGSZUSTANDES EINER ELEKTROCHEMISCHEN BATTERIE, VORRICHTUNG, MEDIUM UND COMPUTERPROGRAMM

METHOD FOR DETERMINING A POWER STATUS OF AN ELECTROCHEMICAL BATTERY; DEVICE; MEDIUM; AND COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2012 FR 1254795**

(43) Date de publication de la demande:
**08.04.2015 Bulletin 2015/15**

(73) Titulaire: **Commissariat à l'Énergie Atomique et aux Énergies Alternatives 75015 Paris (FR)**

(72) Inventeurs:
• **FERNANDEZ, Eric**
  **F-38760 Saint Paul De Varces (FR)**
• **DELAPLAGNE, Tony**
  **73490 La Ravoire (FR)**
• **FRANCHI, Romain**
  **38000 Grenoble (FR)**
• **MAMADOU, Kelli**
  **F-97200 Fort De France (FR)**

(74) Mandataire: **Novaimo
ActiTech 8
60 avenue Marie Curie
Archamps Technopole
74166 Saint Julien-en-Genevois Cedex (FR)**

(56) Documents cités:
**FR-A1- 2 947 637     US-A- 5 151 865
US-A- 5 650 712     US-A1- 2004 220 758**

**EP 2 856 188 B1**

## Description

### Domaine technique de l'invention

L'invention concerne le domaine des accumulateurs électrochimiques.

L'invention a pour objet plus particulièrement un procédé d'estimation d'un état d'énergie final d'un accumulateur électrochimique à partir d'un ensemble de quadruplets de valeurs relatifs à des points de fonctionnement de l'accumulateur électrochimique incluant puissance, température, état d'énergie et énergie restante.

### État de la technique

Traditionnellement, l'indicateur d'état de l'accumulateur est basé sur une évaluation de la quantité de charges électriques stockées dans l'accumulateur. La mesure de l'intensité du courant extrait, et/ou fourni à l'accumulateur, associée à un calcul intégral, permet la réalisation de l'indicateur "d'état de charge" SOC (pour « State Of Charge » en anglais).

Autrement dit, on applique les formulations suivantes :

$$Q = \int i.dt + Q0$$

$$SOC = 100.Q / Q\max$$

où Q représente la quantité de charges stockées dans la batterie à l'instant t en Coulomb,
Q0 représente la quantité de charges initiales stockées dans la batterie en Coulomb,
Qmax représente la quantité de charges maximum de la batterie (batterie pleine) en Coulomb, et
SOC représente un état de charge en pourcentage.

Cet indicateur usuel d'état de charge n'est pas satisfaisant dans la mesure où il ne permet pas de prendre en compte des pertes de l'accumulateur, notamment les pertes dues à sa résistante interne.

En effet, plus la résistance interne d'un accumulateur sera forte, plus la quantité d'énergie restituée sera faible. Dès lors, même si l'accumulateur stocke une très grande quantité de charges, celles réellement disponibles seront plus faibles. La valeur de l'état de charge sera donc faussée, et ce d'autant plus que la résistance interne de l'accumulateur sera élevée.

Il a donc résulté une problématique consistant à trouver un autre indicateur plus représentatif de l'état réel de l'accumulateur.

On connaît du document FR2947637 un procédé de caractérisation de l'état d'énergie d'un accumulateur.

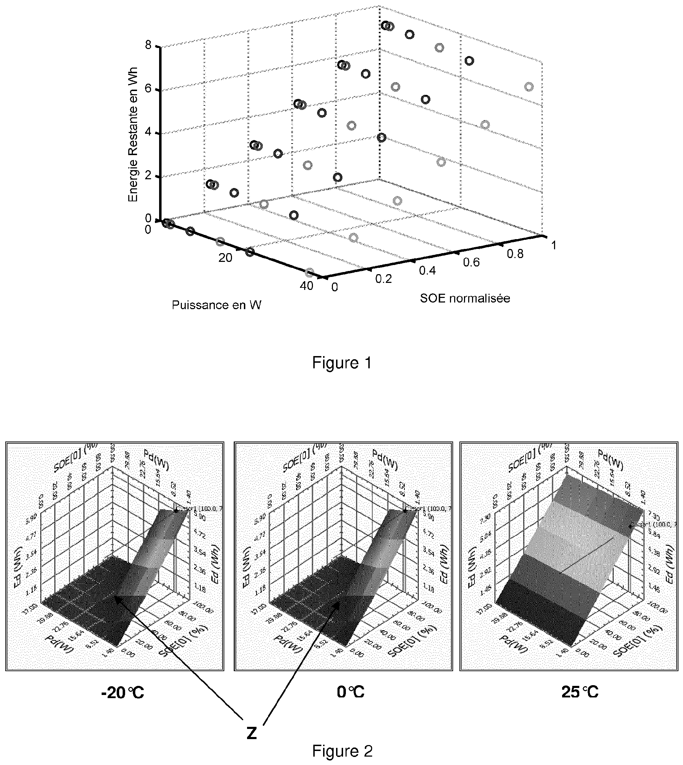

L'objectif de ce procédé est de déterminer quelques points caractéristiques du comportement de l'accumulateur qui définissent un ensemble de valeurs SOE (état d'énergie en Wh), P (puissance utile extraite en W), En (énergie restante en Wh), qui peuvent être représentés par cartographie dans un espace à trois dimensions comme illustré à la figure 1.

L'état d'énergie est relatif à l'énergie disponible à une puissance de référence. Cette puissance de référence peut être celle pour laquelle l'énergie disponible est maximale. L'état d'énergie (SOE "State Of Energy") varie alors de 0 à 1, ou de 0 à 100%. Par exemple, pour un accumulateur dont l'énergie de référence, à la puissance de référence, est de 10Wh, et en prenant un point expérimental SOE=50%, P=20W, En=3Wh, cela signifie que si l'accumulateur est utilisé en réalité à la puissance de 20W, il peut délivrer l'énergie restante de 3Wh (et non pas de 5Wh).

Les valeurs de SOE de la figure 1 permettant un tel raisonnement peuvent être déterminées à partir d'un accumulateur étalon, ou d'un ensemble d'accumulateurs formant batterie, et sont donc normalisées en laboratoire dans un environnement maîtrisé de puissance et d'énergie restante au niveau de l'accumulateur.

Il résulte de cette demande de brevet une problématique d'exploitation de ces données, notamment dans le contexte d'une application embarquée en temps réel où les ressources de calcul sont limitées.

### Objet de l'invention

Le but de la présente invention est de proposer une solution qui remédie aux inconvénients listés ci-dessus et qui permette une résolution rapide de l'état d'énergie.

Pour résoudre ce problème, le procédé d'estimation d'un état d'énergie final SOEf d'un accumulateur électrochimique à partir d'un ensemble de quadruplets de valeurs relatifs à des points de fonctionnement de l'accumulateur électrochimique incluant puissance, température, état d'énergie et énergie restante, peut comprendre :

- une phase de mesure d'une température $T_m$, et d'une puissance $P_m$, représentatives du fonctionnement courant de l'accumulateur,

- une phase de détermination d'un état d'énergie initial *SOE*[0]*,

- une phase d'évaluation d'une énergie restante initiale Eni à partir de l'état d'énergie initial *SOE*[0] et des mesures de puissance $P_m$ et de température $T_m$, et mettant en oeuvre une étape d'interpolation, notamment d'interpolation linéaire, et utilisant au moins des quadruplets de l'ensemble de quadruplets,

- une phase de détermination d'une énergie restante finale Enf, fonction de l'énergie restante initiale Eni et d'une quantité d'énergie prélevée ou fournie à l'accumulateur,

- une phase de détermination de l'état d'énergie final SOEf en fonction de la puissance mesurée $P_m$, de la température mesurée $T_m$ et de l'énergie restante finale Enf, mettant en oeuvre une étape d'interpolation, notamment d'interpolation linéaire.

Selon une mise en oeuvre, la phase d'évaluation de l'énergie restante initiale Eni peut comporter les étapes suivantes :

- déterminer une première énergie restante intermédiaire $En_{T1}$ associée à une température T1 supérieure à la température mesurée $T_m$, et connue de l'ensemble de quadruplets,

- déterminer une seconde énergie restante intermédiaire $En_{T2}$ associée à une température T2 inférieure à la température mesurée $T_m$, et connue de l'ensemble de quadruplets,

- définir l'énergie restante initiale Eni par interpolation linéaire entre les première et seconde énergies restantes intermédiaires.

Avantageusement, chacune des première et seconde énergies restantes intermédiaires $En_{T1}$, $En_{T2}$ est déterminée de la manière suivante :

- à la température associée, choisir trois points intermédiaires dont les coordonnées incluent état d'énergie, puissance et énergie restante issus de l'ensemble de quadruplets, ces trois points intermédiaires étant les plus proches d'un point de fonctionnement intermédiaire courant de l'accumulateur, le point de fonctionnement intermédiaire courant de l'accumulateur étant fonction du premier état d'énergie *SOE*[0]*, et de la puissance Pm mesurée.

- définir une équation de plan cartésien passant par les trois points de fonctionnement intermédiaires choisis,

- déterminer l'énergie restante intermédiaire $En_{Tj}$ en fonction des coefficients de l'équation de plan, de la puissance mesurée $P_m$ et de l'état d'énergie initial *SOE*[0]*.

Les points les plus proches peuvent être déterminés par calcul de distance en utilisant la norme 2.
Selon une mise en oeuvre, l'équation du plan cartésien s'écrivant sous la forme *Ax + By + Cz + D* = 0 avec A, B, C et D étant déterminés en fonction des coordonnées des trois points de fonctionnement intermédiaires choisis, l'énergie restante intermédiaire associée $En_{Tj}$ est calculée selon la formule

$$En_{Tj} = \frac{-\left(A \times SOE[0] + B \times Pm + D\right)}{C}$$

Avantageusement, l'énergie restante initiale Eni est obtenue par interpolation linéaire en application de la formule

$$Eni = \frac{(En_{T2} - En_{T1}) \times (Tm - T1)}{(T2 - T1)} + En_{T1}.$$

Selon une mise en oeuvre, la phase de détermination de l'état d'énergie final SOEf peut comprendre les étapes suivantes :

- déterminer un premier état d'énergie intermédiaire $SOE_{1\text{-}T1}$ associé à une température T1, supérieure à la température mesurée $T_m$ et connue de l'ensemble de quadruplets,

- déterminer un second état d'énergie intermédiaire $SOE_{2\text{-}T2}$ associé à une température T2, inférieure à la température mesurée Tm et connue de l'ensemble de quadruplets,

- définir l'état d'énergie final SOEf par interpolation linéaire entre les premier et second états d'énergie intermédiaires $SOE_{1\text{-}T1}$, $SOE_{2\text{-}T2}$.

Avantageusement, la détermination des premier et second états d'énergie intermédiaires $SOE_{1\text{-}T1}$, $SOE_{2\text{-}T2}$ met en oeuvre les équations des plans cartésiens respectivement associés à la première énergie restante intermédiaire $En_{T1}$ et à la seconde énergie restante intermédiaire $En_{T2}$.

De préférence, chaque état d'énergie intermédiaire est déterminé de la manière suivante :

- déterminer à partir du plan cartésien associé, en fixant la puissance à la valeur de la puissance mesurée $P_m$, une pluralité de couples incluant un état d'énergie associé à une énergie restante,

- choisir parmi la pluralité de couple celui dont la valeur d'énergie restante est la plus proche de l'énergie restante finale Enf, de sorte que la valeur d'état d'énergie correspondante soit considérée comme l'état d'énergie intermédiaire $SOE_{j\text{-}Tj}$ recherché.

Avantageusement, la pluralité de couples est déterminée sur une plage d'état d'énergie située au niveau de l'état d'énergie initial *SOE*[0]. L'état d'énergie initial *SOE*[0] peut être compris dans la plage, ou constitue une borne de la plage. Avantageusement, l'accumulateur étant en phase de charge, l'état d'énergie initial *SOE*[0] constitue la borne inférieure de la plage, ou l'accumulateur étant en phase de décharge l'état d'énergie initial *SOE*[0] constitue la borne supérieure de la plage.

Selon une mise en oeuvre, l'état d'énergie SOEf final est calculé par interpolation linéaire selon l'équation suivante

$$SOEf = \frac{(SOE_{2-T2} - SOE_{1-T1}) \times (T_m - T1)}{(T2 - T1)} + SOE_{1-T1}.$$

Avantageusement, le procédé est itératif, et à la fin d'une itération la valeur de l'état d'énergie initial SOE[0] est remplacée par celle de l'état d'énergie final SOEf.

Selon une mise en oeuvre, l'énergie restante finale Enf est calculée selon la formule Enf=Eni+P.dt où P.dt représente la quantité d'énergie, et est associée à une valeur positive de puissance fournie à l'accumulateur pendant une période déterminée au cours d'une phase de charge, ou à une valeur négative de puissance débitée par l'accumulateur pendant une période déterminée au cours d'une phase de décharge, la période déterminée correspondant au pas de l'itération, notamment compris entre 10ms et 10s, voire égal à 1s.

De préférence, si l'accumulateur est en phase de charge, un coefficient correctif vient pondérer la quantité d'énergie.

L'invention est aussi relative à un dispositif de détermination d'un état d'énergie d'un accumulateur comprenant des moyens matériels et logiciels de mise en oeuvre du procédé d'estimation tel que décrit.

L'invention est aussi relative à un support d'enregistrement de données lisible par un calculateur, sur lequel est enregistré un programme informatique comprenant des moyens de codes de programme informatique exécutable par les moyens logiciels du dispositif tel que décrit pour mettre en oeuvre le procédé d'estimation tel que décrit.

L'invention est aussi relative à un programme informatique comprenant un moyen de codes de programme informatique exécutable par les moyens logiciels du dispositif tel que décrit pour la mise en oeuvre du procédé d'estimation tel que décrit, notamment lorsque le programme est exécuté par un calculateur.

**Description sommaire des dessins**

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 représente la répartition de points de fonctionnement d'un accumulateur en fonction de l'énergie restante, de la puissance et de l'état d'énergie,
- la figure 2 représente une amélioration de la figure 1 dans le sens où la température de fonctionnement de l'accumulateur est aussi prise en compte,
- la figure 3 illustre les phases principales du procédé de détermination de l'état d'énergie,
- la figure 4 illustre un détail d'une phase de la figure 3,
- la figure 5 illustre un détail d'une étape de la figure 4,
- la figure 6 illustre un détail d'une phase de la figure 3,
- la figure 7 illustre un détail d'une étape de la figure 6,
- les figures 8 et 9 illustrent un protocole de test pour valider l'efficacité du procédé de détermination de l'état d'énergie.

**Description de modes préférentiels de l'invention**

Dans le cadre d'une application embarquée, la gestion des ressources pour déterminer un état d'énergie est un paramètre à ne pas négliger. Pour cela, il a été proposé de partir d'un ensemble de valeurs relatives à des points de fonctionnement d'un accumulateur électrochimique. Chaque point incluant une puissance P, un état d'énergie SOE, une énergie restante En, et une température T. La température a été intégrée car elle influe sur le comportement de la résistance interne de l'accumulateur électrochimique.

Autrement dit, l'ensemble peut être représentatif de quadruplets, se présentant par exemple sous la forme d'une table En=f(SOE, P, T). Par table, on entend par exemple une fonction permettant de donner en sortie une valeur, avantageusement unique, d'énergie restante En lorsqu'en entrée on connait des valeurs de SOE, P, et T stockées dans la table.

Ces données peuvent être représentées sous la forme de cartographies comme illustrées à la figure 2. A la figure 2, on se situe dans des espaces à trois dimensions chacun donné par l'énergie restante en Wh, la puissance en W et l'état d'énergie SOE en %. Trois espaces sont représentés de la gauche vers la droite, et sont respectivement associés à une température de -20°C, 0°C et 25°C. Ainsi, pour chaque valeur de température, on a un ensemble de valeurs de puissance, d'état d'énergie et d'énergie restante. Sur la figure 2, pour chaque température les points de fonctionnement sont modélisés sur une nappe représentée en différents tons grisés, et délimitant une surface virtuelle associée à une température. Chaque maille connue de chaque nappe correspond à un point de fonctionnement déterminé par mesure expérimentale fonction du quadruplet (SOE, Energie restante, puissance, température). Le nombre de points de fonctionnement est assez faible, car même si les expériences sont automatisées, elles sont de longue durée.

Avant de détailler les étapes d'un mode d'exécution de l'invention, il convient au préalable d'apporter quelques définitions.

Un état d'énergie, dénommé « State Of Energy » SOE, est défini comme le rapport entre l'énergie $E_{d/PN}$, disponible dans l'hypothèse d'une décharge d'énergie dans les conditions nominales de l'accumulateur, et l'énergie nominale $E_{Nom}$, donc défini par la formule $SOE = E_{d/PN} / E_{Nom}$. Cette valeur de SOE est comprise entre 0 et 1, la valeur égale à 1 correspondant à un état d'énergie de l'accumulateur totalement chargé, et la valeur égale à 0 comme un état totalement déchargé. Cette valeur peut aussi être exprimée en pourcentage.

La puissance P se trouve dans une plage de puissance d'utilisation recommandée par le fabricant de l'accumulateur, soit directement fournie par ce fabricant, soit déduite par exemple d'une plage de courant fournie par ce fabriquant, par multiplication par une tension nominale fournie. Cette puissance est fonction de l'état d'utilisation de l'accumulateur, à savoir la charge ou la décharge. En cas de décharge, on dira que la puissance P est prélevée à l'accumulateur, et en cas de charge, on dira que la puissance P est fournie à l'accumulateur.

Les états chargés et déchargés sont déterminés selon la technologie de l'accumulateur. Ils peuvent être obtenus à partir des recommandations du constructeur de l'accumulateur, et généralement à partir de tensions de seuil.

L'énergie restante En correspond à l'énergie utile de l'accumulateur, elle est exprimée en Wh, et prend en compte l'énergie interne réellement stockée dans l'accumulateur, et l'énergie perdue par effet joule dans la résistance interne de l'accumulateur. Ainsi, on a :

$$En=Ei-Ep$$

Avec

Ep = ∫r.I². dt : représentant l'énergie perdue par effet Joule dans la résistance interne de l'accumulateur, et
Ei = Q.U : l'énergie interne stockée dans l'accumulateur.

L'ensemble de quadruplets peut être généré comme décrit dans la demande de brevet français publiée sous le numéro FR2947637 en prenant en compte en plus la température (Figure 2). En fait, les valeurs d'état d'énergie et d'énergie restante peuvent varier en fonction de la température représentative du fonctionnement de l'accumulateur, c'est pour cela qu'il est avantageux de prendre cette dernière en compte. L'homme du métier sera donc à même de générer un tel ensemble, par exemple par expérimentation.

Ainsi, il a été développé un procédé d'estimation d'un état d'énergie final SOEf d'un accumulateur électrochimique à partir d'un ensemble de quadruplets de valeurs relatifs à des points de fonctionnement de l'accumulateur électrochimique incluant puissance P, température T, état d'énergie SOE, et énergie restante En. Ce procédé est avantageusement itératif, et à la fin d'une itération, la valeur de l'état d'énergie initial *SOE[0]* est remplacée par celle de l'état d'énergie final SOEf, par exemple par modification de la valeur correspondante dans une mémoire.

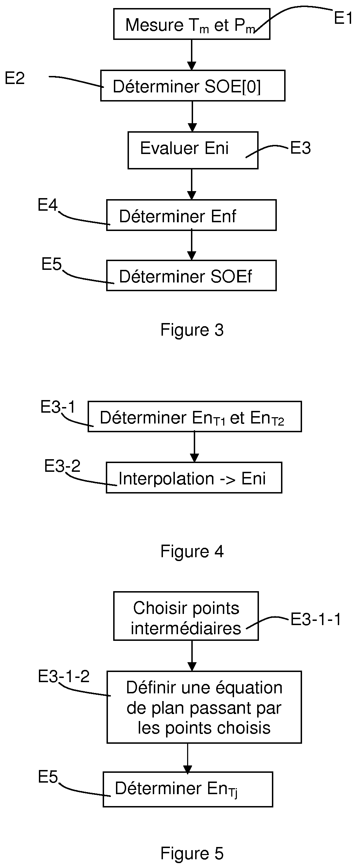

Sur la figure 3, le procédé comporte une phase E1 dans laquelle une température $T_m$ et une puissance $P_m$ sont mesurées. Ces température $T_m$ et puissance $P_m$ sont représentatives du fonctionnement courant de l'accumulateur. Par « courant » on entend l'état de fonctionnement de l'accumulateur notamment au cours de l'itération. Par puissance et température représentatives de l'accumulateur, on entend la puissance à laquelle de l'énergie est prélevée ou fournie à l'accumulateur, et la température de fonctionnement de l'accumulateur. En ce qui concerne les données présentes dans les quadruplets, les valeurs de puissance P stockées sont avantageusement toutes positives. Dès lors, si on mesure une puissance Pm négative, on sait que l'accumulateur est en décharge, et si on mesure une puissance Pm positive, on sait que l'accumulateur est en charge. Dans le cas où les quadruplets ne contiennent que des valeurs positives de puissance, on prendra la valeur absolue de la puissance mesurée Pm pour extraire des données des quadruplets, et le signe de la puissance est utilisé pour savoir si on est en phase de charge, ou de décharge. La température Tm est avantageusement mesurée au plus près de l'accumulateur, en général à sa surface. Dans le cas où l'accumulateur forme une batterie d'accumulateurs élémentaires, il est possible d'utiliser une pluralité de capteurs de température et d'utiliser une moyenne des températures mesurées par ces capteurs en tant que valeur Tm.

Dans une phase E2, un état d'énergie initial *SOE*[0] est déterminé. Cette détermination peut être réalisée par lecture de la valeur correspondante dans la mémoire visée ci-dessus. Typiquement, le procédé étant itératif, dans l'itération en cours, l'état d'énergie initial *SOE*[0] correspond en fait à l'état d'énergie final SOEf de l'itération précédente. Dans le tout premier état d'initialisation, l'accumulateur peut être chargé à son maximum, et lors de l'arrêt de la charge, la valeur de la mémoire est représentative de 100%. Ou inversement, l'accumulateur peut être totalement déchargé, et la valeur mise en mémoire au moment de l'initialisation peut être représentative de 0%.

Bien qu'à la figure 3, la phase E2 soit représentée comme consécutive à la phase E1, elle peut très bien être réalisée avant, concomitamment, ou après la phase E2.

Une fois les valeurs de puissance mesurée $P_m$, de température mesurée $T_m$, et d'état d'énergie initial *SOE[0]* connues, on réalise une phase d'évaluation E3 d'une énergie restante initiale Eni à partir de l'état d'énergie initial *SOE*[0] et des mesures de puissance $P_m$ et de température $T_m$. Cette phase d'évaluation met en oeuvre une étape d'interpolation, notamment d'interpolation linéaire, et utilise au moins des quadruplets de l'ensemble de quadruplets.

La figure 4 illustre une réalisation particulière, et non limitative, de la phase E3. Dans un premier temps E3-1, on détermine une première énergie restante intermédiaire $En_{T1}$ associée à une température T1 supérieure à la température mesurée $T_m$. Cette température T1 est connue de l'ensemble de quadruplets. On détermine aussi une seconde énergie restante intermédiaire $En_{T2}$ associée à une température T2 inférieure à la température mesurée $T_m$. Cette température T2 est connue de l'ensemble de quadruplets. Une fois que ces deux valeurs intermédiaires sont connues, on définit E3-2 l'énergie restante initiale Eni par interpolation linéaire entre les première et seconde énergies restantes intermédiaires.

Pour choisir T1 et T2, on prend dans l'ensemble de quadruplets la valeur de température avantageusement directement supérieure à $T_m$ pour T1, et la valeur de température avantageusement directement inférieure à $T_m$ pour T2. Si Tm= T1, alors Eni est égal à $En_{T1}$, et si Tm=T2 alors Eni est égal à $En_{T2}$.

Avantageusement, l'interpolation linéaire à partir de $En_{T1}$ et $En_{T2}$, permet d'obtenir l'énergie restante initiale Eni en application de la formule

$$Eni = \frac{(En_{T2} - En_{T1}) \times (Tm - T1)}{(T2 - T1)} + En_{T1}.$$

La figure 5 illustre une mise en oeuvre particulière de l'étape E3-1 au cours de laquelle on cherche à déterminer

$En_{T1}$ et $En_{T2}$. Typiquement, à la température associée, c'est-à-dire T1 pour déterminer $En_{T1}$, ou T2 pour déterminer $En_{T2}$, il est choisi trois points intermédiaires E3-1-1 dont les coordonnées incluent état d'énergie, puissance et énergie restante issus de l'ensemble de quadruplets, ces trois points intermédiaires étant les plus proches d'un point de fonctionnement intermédiaire courant de l'accumulateur. Le point de fonctionnement intermédiaire courant de l'accumulateur est fonction du premier état d'énergie *SOE[0]* et de la puissance $P_m$ mesurée. Ainsi, les points intermédiaires les plus proches peuvent être déterminés à partir d'un ensemble de couples d'état d'énergie et de puissance choisis à partir de l'ensemble de quadruplets à la température donnée (le cas échéant selon T1 ou T2). L'ensemble de couples peut être représenté dans un plan donnant l'état d'énergie en fonction de la puissance. Une fois les trois couples choisis, il est possible d'extraire pour chaque couple la valeur d'énergie restante associée, en fonction de la température T1, ou le cas échéant de la température T2, contenue dans l'ensemble de quadruplets. On a ainsi formé les trois points de fonctionnement intermédiaires. Une fois les trois points connus, on définit E3-1-2 une équation de plan cartésien passant par les trois points de fonctionnement intermédiaires choisis. Autrement dit, on va donc déterminer pour la température T1 un plan cartésien à partir de points de fonctionnement intermédiaires déterminés d'un sous-ensemble de points issus de l'ensemble de quadruplets, et tous associés à la même température T1, ce plan cartésien, notamment via ses coefficients, étant ensuite utilisé pour déterminer $En_{T1}$. De même, pour la température T2 on va définir un plan cartésien à partir de points de fonctionnement intermédiaires déterminés à partir d'un sous-ensemble de points issus de l'ensemble de quadruplets, et tous associés à la même température T2, ce plan cartésien, notamment via ses coefficients, étant ensuite utilisé pour déterminer $En_{T2}$.

L'énergie restante intermédiaire ($En_{Tj}$ avec j= 1 ou 2, c'est-à-dire $En_{T1}$, ou le cas échéant $En_{T2}$) est déterminée E3-1-3 à partir des coefficients de l'équation du plan cartésien associé (celui associé à la température T1 pour $En_{T1}$, ou celui associé à la température T2 pour $En_{T2}$), de $P_m$ et de *SOE*[0].

Avantageusement, les points les plus proches sont déterminés par calcul de distance en utilisant la norme 2, typiquement appliqué aux vecteurs définis par deux points chacun associé à une puissance et un état d'énergie. En fait, la norme 2 permet de calculer la « norme » d'un vecteur défini par le point de fonctionnement connu et un des points de fonctionnement intermédiaire. La distance peut être calculée en prenant le couple représentatif du point de fonctionnement intermédiaire courant (SOE[0], Pm) et en réalisant, pour chaque couple de l'ensemble de couples définit ci-avant, un calcul de distance d de la manière suivante : $d = \sqrt{(DeltaSOE^2 + DeltaP^2)}$ en prenant DeltaSOE une valeur de variation séparant SOE[0] de la valeur de $SOE_{test}$ du couple testé issu de l'ensemble de quadruplets à la température donnée T1 ou T2 (par exemple SOE[0] moins $SOE_{test}$) et DeltaP une valeur de variation séparant $P_m$ de la valeur $P_{test}$ du couple issu de l'ensemble de quadruplets à la température donnée T1 ou T2 (par exemple $P_m$ moins $P_{test}$). Ces calculs de distance peuvent être allégés par un préfiltrage dû à un échantillonnage des cartographies.

En fait, l'équation du plan cartésien s'écrivant sous la forme $Ax + By + Cz + D = 0$ (eq1) avec A, B, C et D étant déterminés en fonction des coordonnées des trois points de fonctionnement intermédiaires choisis, à la température associée T1 ou T2, l'énergie restante intermédiaire associée $En_{Tj}$ est calculée selon la formule

$$En_{Tj} = \frac{-(A \times SOE[0] + B \times Pm + D)}{C}$$ , avec j égal à 1 ou 2 le cas échéant.

Ainsi, avec les trois points de fonctionnement intermédiaires choisis M(x1, y1, z1), N(x2, y2, z2) et O(x3, y3, z3) avec x1, x2, x3 les valeurs respectives d'état d'énergie, y1, y2, y3 les valeurs respectives de puissance, et z1, z2, z3 les valeurs respectives d'énergie restante de ces points, on a :

$$A = (y_2 - y_1) \times (z_3 - z_1) - (y_3 - y_1) \times (z_2 - z_1)$$

$$B = -[(x_2 - x_1) \times (z_3 - z_1) - (x_3 - x_1) \times (z_2 - z_1)]$$

$$C = (x_2 - x_1) \times (y_3 - y_1) - (x_3 - x_1) \times (y_2 - y_1)$$

$$D = -(Ax_1 + By_1 + Cz_1)$$

Une fois l'énergie restante initiale Eni connue, une phase de détermination E4 (figure 3) d'une énergie restante finale Enf est réalisée en fonction de l'énergie restante initiale Eni et d'une quantité d'énergie prélevée ou fournie à l'accumulateur. En fait, la quantité d'énergie sera différente si l'accumulateur est au cours d'une phase de charge (énergie fournie à l'accumulateur) ou de décharge (énergie prélevée à l'accumulateur). Autrement dit, l'énergie restante finale Enf peut être calculée selon la formule Enf=Eni+P.dt où P.dt représente la quantité d'énergie, et est associée à une valeur positive de puissance fournie à l'accumulateur pendant une période déterminée au cours d'une phase de charge, ou à une valeur négative de puissance débitée par/prélevée à l'accumulateur pendant une période déterminée au cours d'une phase de décharge. Avantageusement, la période déterminée correspond au pas de l'itération. Le pas de l'itération est avantageusement compris entre 10ms et 10s, notamment égal à 1s. En fait, tout sera lié à la circulation effective de l'information au sein d'un calculateur associé et au rafraichissement des indicateurs.

Dans le cas où l'accumulateur est en phase de charge, un coefficient correctif vient, préférentiellement, pondérer la quantité d'énergie. Le coefficient correctif peut être déterminé à partir d'une table réalisée lors d'une phase d'étalonnage et donnant une valeur de correctif fonction de la température et de l'état de charge. La valeur à utiliser pour la pondération pourra être déterminée lors d'une interpolation par plan cartésien de la table de sorte à trouver une valeur associée à $T_m$ et SOE[0].

Pour terminer, consécutivement à la phase E4, le procédé comporte une phase de détermination E5 de l'état d'énergie final SOEf en fonction de la puissance mesurée $P_m$, de la température mesurée $T_m$ et de l'énergie restante finale Enf, mettant en oeuvre une étape d'interpolation, notamment d'interpolation linéaire et utilisant avantageusement au moins des quadruplets de l'ensemble de quadruplets.

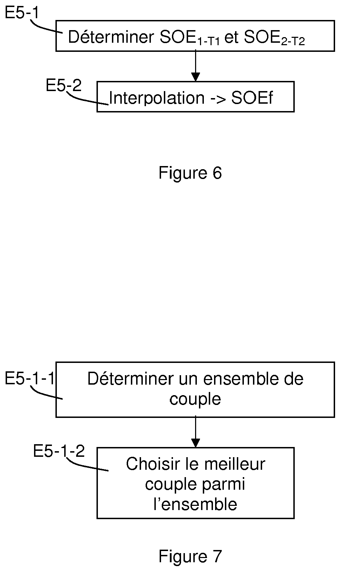

La figure 6 illustre plus en détail un mode de réalisation particulier et non limitatif de la phase E5. Cette phase E5 est découpée en étapes E5-1 et E5-2. Dans l'étape E5-1 on détermine d'une part un premier état d'énergie intermédiaire $SOE_{1-T1}$ associé à une température T1, supérieure à la température mesurée $T_m$ et connue de l'ensemble de quadruplets, et d'autre part un second état d'énergie intermédiaire $SOE_{2-T2}$ associé à une température T2, inférieure à la température mesurée $T_m$ et connue de l'ensemble de quadruplets. En fait, les valeurs de T1 et de T2 sont avantageusement identiques à celles déterminées plus tôt pour calculer les énergies restantes intermédiaires. Dans l'étape E5-2, on définit l'état d'énergie final SOEf par interpolation linéaire entre les premier et second états d'énergie intermédiaires $SOE_{1-T1}$, $SOE_{2-T2}$.

Cette interpolation linéaire est avantageusement mise en oeuvre par l'application de l'équation :

$$SOEf = \frac{\left(SOE_{2-T2} - SOE_{1-T1}\right) \times \left(T_m - T1\right)}{\left(T2 - T1\right)} + SOE_{1-T1}.$$

Selon une mise en oeuvre particulière, la détermination des premier et second états d'énergie intermédiaires $SOE_{1-T1}$, $SOE_{2-T2}$ met en oeuvre les équations des plans cartésiens respectivement associés à la première énergie restante intermédiaire $En_{T1}$ et à la seconde énergie restante intermédiaire $En_{T2}$ (il s'agit ici des équations eq1 définies ci-avant pour les températures T1 et T2). Typiquement pour déterminer $SOE_{1-T1}$ on utilise l'équation du plan cartésien qui a servi à déterminer $En_{T1}$, et pour déterminer $SOE_{2-T2}$ on utilise l'équation du plan cartésien qui a servi à déterminer $En_{T2}$.

Dans ce cas, chaque état d'énergie intermédiaire peut être déterminé selon le raffinement de l'étape E5-1 illustré à la figure 7. Dans un premier temps E5-1-1, on détermine à partir du plan cartésien associé, en fixant la puissance à la valeur de la puissance mesurée $P_m$, une pluralité de couples incluant un état d'énergie associé à une énergie restante. Ces couples peuvent être déterminés à partir de l'équation du plan cartésien associé selon une résolution de pas séparant deux valeurs d'état d'énergie prédéterminée. Ensuite, on choisit E5-1-2 parmi la pluralité de couples celui dont la valeur d'énergie restante est la plus proche de l'énergie restante finale Enf, de sorte que la valeur d'état d'énergie correspondante soit considérée comme l'état d'énergie intermédiaire $SOE_{j-Tj}$ recherché (avec j=1 ou 2). En fait, en considérant l'équation du plan on pourrait tester tous les couples possibles, cependant pour des raisons de temps d'exécution, et de ressources de calcul, on préfèrera déterminer que certains couples.

En réalisant des tests hors de l'application embarquée, il a été déterminé que le couple effectivement choisi était toujours associé à un état d'énergie assez proche de l'état d'énergie initial *SOE*[0]. Ainsi, avantageusement la pluralité de couples est déterminée sur une plage d'état d'énergie située au niveau de l'état d'énergie initial *SOE*[0]. Typiquement, l'état d'énergie initial *SOE*[0] est compris dans la plage, ou constitue une borne de la plage. En fait, si l'accumulateur est en phase de charge, l'état d'énergie initial *SOE*[0] constitue la borne inférieure de la plage. Si l'accumulateur est en phase de décharge l'état d'énergie initial *SOE*[0] constitue la borne supérieure de la plage. Ainsi, connaissant l'équation du plan cartésien, *SOE*[0], et $P_m$, il est facile de tester plusieurs valeurs d'état d'énergie proches de *SOE*[0] pour déterminer la valeur de l'énergie restante associée afin de la comparer à l'énergie restante finale.

La définition de cette plage correspond en fait à délimiter une fenêtre de recherche de +/- 0,1% à partir de *SOE*[0]. Typiquement, il sera réalisé 10 calculs d'interpolation en partant la valeur de *SOE*[0] selon un pas de 0,01% si on sait si l'accumulateur est en phase de charge ou de décharge. En fait, en fonction des ressources disponibles pour réaliser les calculs, le choix des paramètres de filtrage, c'est-à-dire la taille de la fenêtre et le pas de calcul, peuvent être dépendant de l'application et du pas d'échantillonnage temporel. Ces calculs sont réalisés selon une évolution positive à partir de *SOE*[0] si l'accumulateur est en charge, ou selon une évolution négative si l'accumulateur est en décharge.

Un support d'enregistrement de données lisible par un calculateur, sur lequel est enregistré un programme informatique peut comprendre des moyens de codes de programme informatique de mise en oeuvre des phases et/ou des étapes du procédé de détermination de l'état d'énergie final SOEf.

Un programme informatique comprenant un moyen de codes de programme informatique peut être adapté à la réalisation des phases et/ou des étapes du procédé de détermination de l'état d'énergie, lorsque le programme est exécuté par un calculateur.

Un dispositif de détermination d'un état d'énergie d'un accumulateur électrochimique peut comporter : un élément de stockage du premier ensemble ; un élément de mesure d'une température $T_m$, et d'une puissance $P_m$, représentatives du fonctionnement courant de l'accumulateur ; un élément de détermination d'un état d'énergie initial *SOE*[0]*,* comprenant notamment une mémoire ; un élément configuré pour évaluer une énergie restante initiale Eni à partir des mesures de puissance $P_m$, de température $T_m$ et de l'état d'énergie initial *SOE*[0] mettant en oeuvre une étape d'interpolation, notamment d'interpolation linéaire, et utilisant l'ensemble de quadruplets ; un élément configuré pour déterminer une énergie restante finale Enf, fonction de l'énergie restante initiale Eni et d'une quantité d'énergie prélevée ou fournie à l'accumulateur ; un élément configuré pour déterminer l'état d'énergie final SOEf en fonction de la puissance mesurée $P_m$, de la température mesurée $T_m$ et de l'énergie restante finale Enf, mettant en oeuvre une étape d'interpolation, notamment d'interpolation linéaire, et avantageusement utilisant au moins des quadruplets l'ensemble de quadruplets.

De manière générale, le dispositif peut comprendre des moyens matériels et/ou logiciels de mise en oeuvre des étapes/phases du procédé de détermination tel que décrit (plus particulièrement, les moyens matériels et/ou logiciels peuvent mettre en oeuvre le procédé de détermination tel que décrit).

Notamment, le dispositif peut comporter pour chaque phase et/ou étape du procédé un élément dédié et configuré pour réaliser la phase et/ou ladite étape.

On comprend alors de ce qui a été dit ci-dessus que le programme informatique du support d'enregistrement peut comprendre des moyens de codes de programme informatique exécutable par les moyens logiciels du dispositif tel que décrit pour mettre en oeuvre le procédé tel que décrit.

Par ailleurs, on comprend aussi que le programme informatique peut comprendre un moyen de codes de programme informatique exécutable par les moyens logiciels du dispositif tel que décrit pour la mise en oeuvre du procédé tel que décrit, notamment lorsque le programme est exécuté par un calculateur.

Afin de tester le présent procédé de détermination, un profil de puissance, présentant des phases de charge et de décharge, a été appliqué à un accumulateur. Pendant le test, la tension aux bornes de l'accumulateur et la température de l'accumulateur ont été relevés.

D'autre part, le profil de puissance et la température de fonctionnement de l'accumulateur sont injectés dans une simulation de l'algorithme de calcul d'estimation de l'état d'énergie présenté précédemment. Dans le cadre de cette simulation il a été utilisé :

- les cartographies expérimentales (6 valeurs de SOE par 6 valeurs de P par 6 valeurs de T soit 288 valeurs En associées, autrement dit 288 quadruplets)
- la méthode d'interpolation par les plans cartésiens présentée précédemment
- Une précision de calcul du SOE à 0.01% et une plage de calcul de 0,1 %

L'algorithme itératif correspond à un pas de temps dt = 1s.

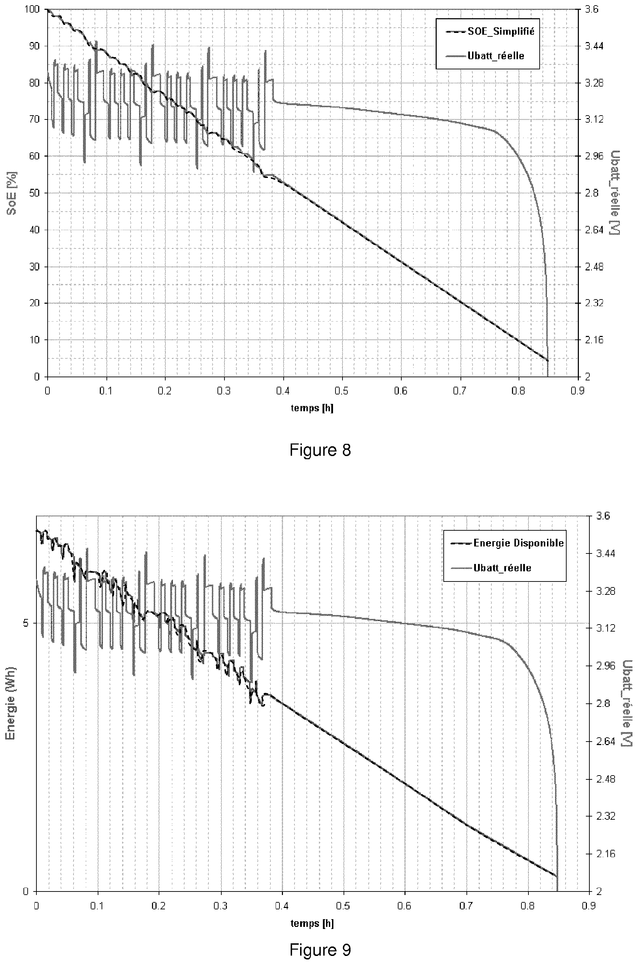

Les résultats d'état d'énergie simulé et de la tension réellement mesurée peuvent alors être comparés. La figure 8 illustre l'évolution de la tension Ubatt_réelle de l'accumulateur en fonction du temps (en heure h) et l'évolution de l'état d'énergie (SOE en %) en fonction du temps (en heure h) au cours d'une phase de décharge de l'accumulateur. La figure 9 illustre l'évolution de la tension de la batterie Ubatt_réelle en fonction du temps (en heure h) et l'évolution de l'énergie restante (Wh) en fonction du temps (en heure h) au cours d'une phase de décharge de l'accumulateur. Les figures 8 et 9 montrent qu'en fin de décharge, l'état d'énergie (SOE) et l'énergie disponible sont effectivement proches de 0 (<4% pour SOE ~ 250mWh pour l'énergie restante disponible). Cette estimation est suffisante dans le cadre d'une application embarquée dont les ressources sont limitées.

Comme indiqué précédemment, l'ensemble de quadruplets peut être issu de données expérimentales. Avant d'être utilisé dans le cadre du présent procédé, cet ensemble peut être complété par interpolation. Cette interpolation peut être effectuée en température, en état d'énergie et en puissance. Avantageusement, plus les fonctions de l'état d'énergie par rapport à la puissance d'utilisation et de la température sont irrégulières, plus le nombre de points de modélisation doit être important. Il est envisageable d'augmenter le nombre de points de modélisation uniquement aux endroits où se situent les irrégularités. Typiquement à la figure 2, la référence Z indique une telle irrégularité. L'augmentation du nombre de points au niveau des irrégularités uniquement peut permettre de diminuer la taille de la mémoire contenant la cartographie au détriment de la simplicité de recherche dans la mémoire lors de l'exécution de l'application.

Les cartographies représentant les quadruplets peuvent être générées sur ordinateur à l'aide de logiciels de calculs scientifiques tels que matlab, mathcab, octave, scilab, etc., ou alors être simplement issues des points expérimentaux selon le besoin.

Ainsi, l'ensemble de quadruplets utilisé dans le cadre de la détermination de l'état d'énergie, issue de données expérimentales complétées ou non, peut être stocké dans une mémoire qui sera utilisée par un calculateur. En fait plus l'ensemble de quadruplets comporte de valeurs, plus l'algorithme sera précis.

La description mentionne un accumulateur électrochimique. La définition de l'accumulateur doit être prise au sens large, et vise tout aussi bien un accumulateur élémentaire ou une pluralité d'accumulateurs élémentaires agencés sous forme d'une batterie. L'accumulateur de référence utilisé pour les tests provient du fabricant A123system et porte la référence ANR26650M1.

Il a été utilisé ci-dessus des plans cartésiens pour approcher au mieux la valeur d'état d'énergie. Il est possible d'utiliser à la place des plans cartésiens une interpolation linéaire par hyperplan d'ordre 3 dans un espace d'ordre 4 à partir de l'ensemble de quadruplets. Cependant cette réalisation ne sera pas préférée car trop gourmande en ressources de calcul.

Selon une réalisation, en fin d'itération on peut comparer SOEf à SOE[0] de sorte que si ces deux derniers sont égaux, c'est-à-dire que la jauge n'a pas bougé, on intègre quand même la variation d'énergie au pas suivant au lieu de refaire le calcul de Eni par interpolation inverse. L'intégration se poursuit d'itération en itération jusqu'à ce que l'on trouve un état d'énergie différent du pas précédent. Ceci permet d'être plus précis si une faible puissance est débitée pendant longtemps.

**Revendications**

1. Procédé d'estimation d'un état d'énergie final SOEf d'un accumulateur électrochimique à partir d'un ensemble de quadruplets de valeurs relatifs à des points de fonctionnement de l'accumulateur électrochimique incluant puissance (P), température (T), état d'énergie (SOE) et énergie restante (En), ledit procédé comprenant :

   - une phase de mesure (E1) d'une température $T_m$, et d'une puissance $P_m$, représentatives du fonctionnement courant de l'accumulateur,
   - une phase de détermination (E2) d'un état d'énergie initial *SOE*[0]*,
   - une phase d'évaluation (E3) d'une énergie restante initiale Eni à partir de l'état d'énergie initial *SOE*[0] et des mesures de puissance $P_m$ et de température $T_m$, et mettant en oeuvre une étape d'interpolation, notamment d'interpolation linéaire, et utilisant au moins des quadruplets de l'ensemble de quadruplets,
   - une phase de détermination (E4) d'une énergie restante finale Enf, fonction de l'énergie restante initiale Eni et d'une quantité d'énergie prélevée ou fournie à l'accumulateur,
   - une phase de détermination (E5) de l'état d'énergie final SOEf en fonction de la puissance mesurée $P_m$, de la température mesurée $T_m$ et de l'énergie restante finale Enf, mettant en oeuvre une étape d'interpolation, notamment d'interpolation linéaire.

2. Procédé selon la revendication 1, **caractérisé en ce que** la phase d'évaluation de l'énergie restante initiale Eni comporte les étapes suivantes :

   - déterminer (E3-1) une première énergie restante intermédiaire $En_{T1}$ associée à une température T1 supérieure à la température mesurée $T_m$, et connue de l'ensemble de quadruplets,
   - déterminer (E3-1) une seconde énergie restante intermédiaire $En_{T2}$ associée à une température T2 inférieure à la température mesurée $T_m$, et connue de l'ensemble de quadruplets,
   - définir (E3-2) l'énergie restante initiale Eni par interpolation linéaire entre les première et seconde énergies restantes intermédiaires.

3. Procédé selon la revendication 2, **caractérisé en ce que** chacune des première et seconde énergies restantes intermédiaires $En_{T1}$, $En_{T2}$ est déterminée de la manière suivante :

   - à la température associée, choisir (E3-1-1) trois points intermédiaires dont les coordonnées incluent état d'énergie, puissance et énergie restante issus de l'ensemble de quadruplets, ces trois points intermédiaires étant les plus proches d'un point de fonctionnement intermédiaire courant de l'accumulateur, le point de fonctionnement intermédiaire courant de l'accumulateur étant fonction du premier état d'énergie *SOE*[0]*, et de la puissance Pm mesurée,
   - définir (E3-1-2) une équation de plan cartésien passant par les trois points de fonctionnement intermédiaires choisis,
- déterminer (E3-1-3) l'énergie restante intermédiaire $En_{Tj}$ en fonction des coefficients de l'équation de plan, de la puissance mesurée $P_m$ et de l'état d'énergie initial $SOE[0]$.

4. Procédé selon la revendication 3, **caractérisé en ce que** les points les plus proches sont déterminés par calcul de distance en utilisant la norme 2.

5. Procédé selon l'une des revendications 3 et 4, **caractérisé en ce que** l'équation du plan cartésien s'écrivant sous la forme $Ax + By + Cz + D = 0$ avec A, B, C et D étant déterminés en fonction des coordonnées des trois points de fonctionnement intermédiaires choisis, l'énergie restante intermédiaire associée $En_{Tj}$ est calculée selon la formule

$$En_{Tj} = \frac{-(A \times SOE[0] + B \times Pm + D)}{C}$$

6. Procédé selon l'une quelconque des revendications 2 à 5, **caractérisé en ce que** l'énergie restante initiale Eni est obtenue par interpolation linéaire en application de la formule

$$Eni = \frac{(En_{T2} - En_{T1}) \times (Tm - T1)}{(T2 - T1)} + En_{T1}$$

7. Procédé selon l'une des revendications 1 à 6, **caractérisé en ce que** la phase de détermination de l'état d'énergie final SOEf comprend les étapes suivantes :

- déterminer (E5-1) un premier état d'énergie intermédiaire $SOE_{1-T1}$ associé à une température T1, supérieure à la température mesurée $T_m$ et connue de l'ensemble de quadruplets,
- déterminer (E5-1) un second état d'énergie intermédiaire $SOE_{2-T2}$ associé à une température T2, inférieure à la température mesurée Tm et connue de l'ensemble de quadruplets,
- définir (E5-2) l'état d'énergie final SOEf par interpolation linéaire entre les premier et second états d'énergie intermédiaires $SOE_{1-T1}$, $SOE_{2-T2}$.

8. Procédé selon la revendication 7 et la revendication 3, **caractérisé en ce que** la détermination des premier et second états d'énergie intermédiaires $SOE_{1-T1}$, $SOE_{2-T2}$ met en oeuvre les équations des plans cartésiens respectivement associés à la première énergie restante intermédiaire $En_{T1}$ et à la seconde énergie restante intermédiaire $En_{T2}$.

9. Procédé selon la revendication 8, **caractérisé en ce que** chaque état d'énergie intermédiaire est déterminé de la manière suivante :

- déterminer (E5-1-1) à partir du plan cartésien associé, en fixant la puissance à la valeur de la puissance mesurée $P_m$, une pluralité de couples incluant un état d'énergie associé à une énergie restante,
- choisir (E5-1-2) parmi la pluralité de couple celui dont la valeur d'énergie restante est la plus proche de l'énergie restante finale Enf, de sorte que la valeur d'état d'énergie correspondante soit considérée comme l'état d'énergie intermédiaire $SOE_{j-Tj}$ recherché.

10. Procédé selon la revendication 9, **caractérisé en ce que** la pluralité de couples est déterminée sur une plage d'état d'énergie située au niveau de l'état d'énergie initial $SOE[0]$.

11. Procédé selon la revendication 10, **caractérisé en ce que** l'état d'énergie initial $SOE[0]$ est compris dans la plage, ou constitue une borne de la plage.

12. Procédé selon la revendication 11, **caractérisé en ce que** l'accumulateur étant en phase de charge, l'état d'énergie initial $SOE[0]$ constitue la borne inférieure de la plage, ou **en ce que** l'accumulateur étant en phase de décharge l'état d'énergie initial $SOE[0]$ constitue la borne supérieure de la plage.

13. Procédé selon l'une des revendications 7 à 11, **caractérisé en ce que** l'état d'énergie SOEf final est calculé par interpolation linéaire selon l'équation suivante

$$SOEf = \frac{(SOE_{2-T2} - SOE_{1-T1}) \times (T_m - T1)}{(T2 - T1)} + SOE_{1-T1}.$$

**14.** Procédé selon l'une quelconque des revendications 1 à 13, **caractérisé en ce qu'**il est itératif, et **en ce qu'**à la fin d'une itération la valeur de l'état d'énergie initial SOE[0] est remplacée par celle de l'état d'énergie final SOEf.

**15.** Procédé selon la revendication 14, **caractérisé en ce que** l'énergie restante finale Enf est calculée selon la formule Enf=Eni+P.dt où P.dt représente la quantité d'énergie, et est associée à une valeur positive de puissance fournie à l'accumulateur pendant une période déterminée au cours d'une phase de charge, ou à une valeur négative de puissance débitée par l'accumulateur pendant une période déterminée au cours d'une phase de décharge, la période déterminée correspondant au pas de l'itération, notamment compris entre 10ms et 10s, voire égal à 1s.

**16.** Procédé selon l'une des revendications 1 à 15, **caractérisé en ce que** l'accumulateur étant en phase de charge, un coefficient correctif vient pondérer la quantité d'énergie.

**17.** Dispositif de détermination d'un état d'énergie d'un accumulateur comprenant des moyens matériels et logiciels configurés pour mettre en oeuvre le procédé selon l'une des revendications 1 à 16.

**18.** Support d'enregistrement de données lisible par un calculateur, sur lequel est enregistré un programme informatique comprenant des moyens de codes de programme informatique exécutable par les moyens matériels du dispositif selon la revendication 17 pour mettre en oeuvre le procédé selon l'une des revendications 1 à 16.

**19.** Programme informatique comprenant un moyen de codes de programme informatique exécutable par les moyens matériels du dispositif selon la revendication 17 pour la mise en oeuvre du procédé selon l'une des revendications 1 à 16.

**Patentansprüche**

**1.** Verfahren zur Schätzung eines Endenergiezustands SOEf eines elektrochemischen Akkumulators ausgehend von einer Gesamtheit von Wertequadrupeln zu Betriebspunkten des elektrochemischen Akkumulators, die Leistung (P), Temperatur (T), Energiezustand (SOE) und Restenergie (En) beinhalten, wobei das Verfahren umfasst:

- eine Phase des Messens (E1) einer Temperatur $T_m$ und einer Leistung $P_m$, die für den aktuellen Betrieb des Akkumulators repräsentativ sind,
- eine Phase des Bestimmens (E2) eines Ausgangsenergiezustands *SOE*[0]*,
- eine Phase des Evaluierens (E3) einer Ausgangsrestenergie Eni ausgehend vom Ausgangsenergiezustand *SOE*[0] und von den Messungen von Leistung $P_m$ und Temperatur $T_m$ und unter Einsatz eines Schritts der Interpolation, insbesondere einer linearen Interpolation, und unter Verwendung mindestens einiger Quadrupel der Gesamtheit von Quadrupeln,
- eine Phase des Bestimmens (E4) einer Endrestenergie Enf in Abhängigkeit von der Ausgangsrestenergie Eni und einer dem Akkumulator entnommenen oder dem Akkumulator zugeführten Energiemenge,
- eine Phase des Bestimmens (E5) des Endenergiezustands SOEf in Abhängigkeit von der gemessenen Leistung $P_m$, der gemessenen Temperatur $T_m$ und der Endrestenergie Enf unter Einsatz eines Schritts der Interpolation, insbesondere einer linearen Interpolation.

**2.** Verfahren nach Anspruch 1, **dadurch gekennzeichnet, dass** die Phase des Evaluierens der Ausgangsrestenergie Eni die folgenden Schritte umfasst:

- Bestimmen (E3-1) einer ersten Zwischenrestenergie $En_{T1}$, die einer Temperatur T1 zugeordnet ist, die über der gemessenen Temperatur $T_m$ liegt und aus der Gesamtheit von Quadrupeln bekannt ist,
- Bestimmen (E3-1) einer zweiten Zwischenrestenergie $En_{T2}$, die einer Temperatur T2 zugeordnet ist, die unter der gemessenen Temperatur $T_m$ liegt und aus der Gesamtheit von Quadrupeln bekannt ist,
- Definieren (E3-2) der Ausgangsrestenergie Eni durch lineare Interpolation zwischen den ersten und zweiten Zwischenrestenergien.

**3.** Verfahren nach Anspruch 2, **dadurch gekennzeichnet, dass** jede der ersten und zweiten Zwischenrestenergien

$En_{T1}$, $En_{T2}$ folgendermaßen bestimmt wird:

- bei der zugeordneten Temperatur Wählen (E3-1-1) von drei Zwischenpunkten, deren Koordinaten Energiezustand, Leistung und Restenergie beinhalten, aus der Gesamtheit von Quadrupeln, wobei diese drei Zwischenpunkte die nächstgelegenen zu einem aktuellen Zwischenbetriebspunkt des Akkumulators sind, wobei der aktuelle Zwischenbetriebspunkt des Akkumulators von dem ersten Energiezustand *SOE*[0] und von der gemessenen Leistung $P_m$ abhängig ist,
- Definieren (E3-1-2) einer Ebenengleichung in Koordinatenform, die durch die drei gewählten Zwischenbetriebspunkte verläuft,
- Bestimmen (E3-1-3) der Zwischenrestenergie $En_{Tj}$ in Abhängigkeit von den Koeffizienten der Ebenengleichung, der gemessenen Leistung $P_m$ und des Ausgangsenergiezustands *SOE*[0].

4. Verfahren nach Anspruch 3, **dadurch gekennzeichnet, dass** die nächstgelegenen Punkte durch Abstandsberechnung unter Verwendung der Norm 2 bestimmt werden.

5. Verfahren nach einem der Ansprüche 3 und 4, **dadurch gekennzeichnet, dass**, wenn sich die Ebenengleichung in Koordinatenform in der Form *Ax* + *By* + *Cz*+ *D* = 0 schreibt, wobei A, B, C und D in Abhängigkeit von den Koordinaten der drei gewählten Zwischenbetriebspunkte bestimmt werden, die zugeordnete Zwischenrestenergie $En_{Tj}$ nach der folgenden Formel berechnet wird:

$$En_{Tj} = \frac{-(A \times SOE[0] + B \times Pm + D)}{C}$$

6. Verfahren nach einem der Ansprüche 2 bis 5, **dadurch gekennzeichnet, dass** die Ausgangsrestenergie Eni durch lineare Interpolation in Anwendung der folgenden Formel erhalten wird:

$$Eni = \frac{(En_{T2} - En_{T1}) \times (Tm - T1)}{(T2 - T1)} + En_{T1}$$

7. Verfahren nach einem der Ansprüche 1 bis 6, **dadurch gekennzeichnet, dass** die Phase des Bestimmens der Endrestenergie SOEf die folgenden Schritte umfasst:

- Bestimmen (E5-1) eines ersten Zwischenenergiezustands $SOE_{1-T1}$, der einer Temperatur T1 zugeordnet ist, die über der gemessenen Temperatur $T_m$ liegt und aus der Gesamtheit von Quadrupeln bekannt ist,
- Bestimmen (E5-1) eines zweiten Zwischenenergiezustands $SOE_{2-12}$, der einer Temperatur T2 zugeordnet ist, die unter der gemessenen Temperatur $T_m$ liegt und aus der Gesamtheit von Quadrupeln bekannt ist,
- Definieren (E5-2) des Endenergiezustands SOEf durch lineare Interpolation zwischen den ersten und zweiten Zwischenenergiezuständen $SOE_{1-T1}$, $SOE_{2-T2}$.

8. Verfahren nach Anspruch 7 und Anspruch 3, **dadurch gekennzeichnet, dass** die Bestimmung der ersten und zweiten Zwischenenergiezustände $SOE_{1-T1}$, $SOE_{2-T2}$ die Ebenengleichungen in Koordinatenform einsetzt, die jeweils der ersten Zwischenrestenergie $En_{T1}$ und der zweiten Zwischenrestenergie $En_{T2}$ zugeordnet sind.

9. Verfahren nach Anspruch 8, **dadurch gekennzeichnet, dass** jeder Zwischenenergiezustand folgendermaßen bestimmt wird:

- Bestimmen (E5-1-1) einer Vielzahl von Paaren, die einen einer Restenergie zugeordneten Energiezustand beinhalten, ausgehend von der zugeordneten Koordinatenebene unter Festlegung der Leistung auf den gemessenen Wert der Leistung $P_m$,
- Auswählen (E5-1-2) desjenigen unter der Vielzahl von Paaren, dessen Restenergiewert am nächstgelegenen zur Endrestenergie Enf ist, so dass der entsprechende Energiezustandswert als gesuchter Zwischenenergiezustand $SOE_{j-Tj}$ betrachtet wird.

10. Verfahren nach Anspruch 9, **dadurch gekennzeichnet, dass** die Vielzahl von Paaren über einen Energiezustandsbereich bestimmt wird, der auf Ebene des Ausgangsenergiezustands *SOE*[0] liegt.

**11.** Verfahren nach Anspruch 10, **dadurch gekennzeichnet, dass** der Ausgangsenergiezustand *SOE*[0] in dem Bereich enthalten ist oder einen Grenzwert des Bereichs bildet.

**12.** Verfahren nach Anspruch 11, **dadurch gekennzeichnet, dass**, wenn der Akkumulator in der Ladephase ist, der Ausgangsenergiezustand *SOE*[0] den unteren Grenzwert des Bereichs bildet oder dass, wenn der Akkumulator in der Entladephase ist, der Ausgangsenergiezustand *SOE*[0] den oberen Grenzwert des Bereichs bildet.

**13.** Verfahren nach einem der Ansprüche 7 bis 11, **dadurch gekennzeichnet, dass** der Endenergiezustand SOEf durch lineare Interpolation nach der folgenden Gleichung berechnet wird:

$$SOEf = \frac{(SOE_{2-T2} - SOE_{1-T1}) \times (T_m - T1)}{(T2 - T1)} + SOE_{1-T1}$$

**14.** Verfahren nach einem der Ansprüche 1 bis 13, **dadurch gekennzeichnet, dass** es iterativ ist und dass der Wert des Ausgangsenergiezustands SOE[0] am Ende einer Iteration durch den des Endenergiezustands SOEf ersetzt wird.

**15.** Verfahren nach Anspruch 14, **dadurch gekennzeichnet, dass** die Endrestenergie Enf nach der Formel Enf=Eni+P.dt berechnet wird, worin P.dt die Energiemenge repräsentiert, und einem positiven Leistungswert zugeordnet ist, der dem Akkumulator während eines bestimmten Zeitraums in einer Ladephase zugeführt wird, oder einem negativen Leistungswert zugeordnet ist, der vom Akkumulator während eines bestimmten Zeitraums in einer Entladephase abgegeben wird, wobei der bestimmte Zeitraum dem Iterationsschritt entspricht, insbesondere zwischen 10ms und 10s beträgt oder sogar gleich 1s ist.

**16.** Verfahren nach einem der Ansprüche 1 bis 15, **dadurch gekennzeichnet, dass**, wenn der Akkumulator in der Ladephase ist, die Energiemenge durch einen Korrekturbeiwert gewichtet wird.

**17.** Vorrichtung zur Bestimmung eines Energiezustands eines Akkumulators, umfassend Hardware- und Softwaremittel, die dazu ausgestaltet sind, das Verfahren nach einem der Ansprüche 1 bis 16 durchzuführen.

**18.** Rechnerlesbares Datenspeichermedium, auf dem ein Computerprogramm gespeichert ist, das Computerprogrammcodemittel umfasst, die von den Hardwaremitteln der Vorrichtung nach Anspruch 17 ausführbar sind, um das Verfahren nach einem der Ansprüche 1 bis 16 durchzuführen.

**19.** Computerprogramm, umfassend ein Computerprogrammcodemittel, das von den Hardwaremitteln der Vorrichtung nach Anspruch 17 ausführbar ist, um das Verfahren nach einem der Ansprüche 1 bis 16 durchzuführen.

**Claims**

**1.** Method for estimating a final state of energy SOEf of an electrochemical accumulator from a set of quadruplets of values relating to operating points of the electrochemical accumulator including power (P), temperature (T), state of energy (SOE) and remaining energy (En), said method including:

- a phase of measuring (E1) a temperature $T_m$, and a power $P_m$, representative of the current operation of the accumulator,
- a phase of determining (E2) an initial state of energy *SOE*[0],
- a phase of evaluating (E3) an initial remaining energy Eni based on the initial state of energy *SOE*[0] and the measurements of power $P_m$ and temperature $T_m$, and implementing a step of interpolation, in particular linear interpolation, and using at least some quadruplets from the set of quadruplets,
- a phase of determining (E4) a final remaining energy Enf, a function of the initial remaining energy Eni and an amount of energy drawn from or supplied to the accumulator,
- a phase of determining (E5) the final state of energy SOEf as a function of the measured power $P_m$, the measured temperature $T_m$ and the final remaining energy Enf, implementing a step of interpolation, in particular linear interpolation.

**2.** Method according to Claim 1, **characterized in that** the phase of evaluating the initial remaining energy Eni comprises the following steps:

- determining (E3-1) a first intermediate remaining energy $En_{T1}$ associated with a temperature T1 higher than the measured temperature $T_m$, and known from the set of quadruplets,
- determining (E3-1) a second intermediate remaining energy $En_{T2}$ associated with a temperature T2 lower than the measured temperature $T_m$, and known from the set of quadruplets,
- defining (E3-2) the initial remaining energy Eni by linear interpolation between the first and second intermediate remaining energies.

3. Method according to Claim 2, **characterized in that** each of the first and second intermediate remaining energies $En_{T1}$, $En_{T2}$ is determined in the following way:

- at the associated temperature, selecting (E3-1-1) three intermediate points, the coordinates of which include state of energy, power and remaining energy derived from the set of quadruplets, these three intermediate points being the closest to a current intermediate operating point of the accumulator, the current intermediate operating point of the accumulator being a function of the first state of energy *SOE*[0]*,* and of the measured power Pm,
- defining (E3-1-2) a Cartesian plane equation passing through three selected intermediate operating points,
- determining (E3-1-3) the intermediate remaining energy $En_{Tj}$ as a function of the coefficients of the plane equation, the measured power Pm and the initial state of energy *SOE*[0].

4. Method according to Claim 3, **characterized in that** the closest points are determined by distance calculation using the 2-norm.

5. Method according to one of Claims 3 and 4, **characterized in that**, the Cartesian plane equation being written in the form $Ax + By + Cz + D = 0$ with A, B, C and D being determined according to the coordinates of the three selected intermediate operating points, the associated intermediate remaining energy $En_{Tj}$ is calculated according to the formula

$$En_{Tj} = \frac{-\left(A \times SOE[0] + B \times Pm + D\right)}{C}.$$

6. Method according to any one of Claims 2 to 5, **characterized in that** the initial remaining energy Eni is obtained by linear interpolation in accordance with the formula

$$Eni = \frac{\left(En_{T2} - En_{T1}\right) \times (Tm - T1)}{(T2 - T1)} + En_{T1}.$$

7. Method according to one of Claims 1 to 6, **characterized in that** the phase of determining the final state of energy SOEf includes the following steps:

- determining (E5-1) a first intermediate state of energy $SOE_{1-T1}$ associated with a temperature T1, higher than the measured temperature $T_m$ and known from the set of quadruplets,
- determining (E5-1) a second intermediate state of energy $SOE_{2-T2}$ associated with a temperature T2, lower than the measured temperature Tm and known from the set of quadruplets,
- defining (E5-2) the final state of energy SOEf by linear interpolation between the first and second intermediate states of energy $SOE_{1-T1}$, $SOE_{2-T2}$.

8. Method according to Claim 7 and Claim 3, **characterized in that** the determination of the first and second intermediate states of energy $SOE_{1-T1}$, $SOE_{2-T2}$ implements the Cartesian plane equations respectively associated with the first intermediate remaining energy $En_{T1}$ and the second intermediate remaining energy $En_{T2}$.

9. Method according to Claim 8, **characterized in that** each intermediate state of energy is determined in the following way:

- determining (E5-1-1) from the associated Cartesian plane, by setting the power to the value of the measured

15

power $P_m$, a plurality of pairs including a state of energy associated with a remaining energy,
- selecting (E5-1-2) from the plurality of pairs the one whereof the remaining energy value is closest to the final remaining energy Enf, so that the corresponding state of energy value is treated as the intermediate state of energy $SOE_{j-Tj}$ sought.

10. Method according to Claim 9, **characterized in that** the plurality of pairs is determined over a state of energy range at the level of the initial state of energy $SOE[0]$

11. Method according to Claim 10, **characterized in that** the initial state of energy $SOE[0]$ is included in the range, or constitutes a boundary of the range.

12. Method according to Claim 11, **characterized in that**, the accumulator being in charge phase, the initial state of energy $SOE[0]$ constitutes the lower boundary of the range, or **in that**, the accumulator being in discharge phase, the initial state of energy $SOE[0]$ constitutes the upper boundary of the range.

13. Method according to one of Claims 7 to 11, **characterized in that** the final state of energy SOEf is calculated by linear interpolation using the following equation

$$ SOEf = \frac{(SOE_{2-T2} - SOE_{1-T1}) \times (T_m - T1)}{(T2 - T1)} + SOE_{1-T1}. $$

14. Method according to any one of Claims 1 to 13, **characterized in that** it is iterative, and **in that** at the end of an iteration the value of the initial state of energy SOE[0] is replaced by that of the final state of energy SOEf.

15. Method according to Claim 14, **characterized in that** the final remaining energy Enf is calculated using the formula Enf = Eni + P.dt where P.dt represents the amount of energy, and is associated with a positive value of power supplied to the accumulator during a determined period in the course of a charge phase, or with a negative value of power output by the accumulator during a determined period in the course of a discharge phase, the determined period corresponding to the iteration interval, in particular between 10 ms and 10 s, or even equal to 1 s.

16. Method according to one of Claims 1 to 15, **characterized in that**, the accumulator being in charge phase, a correction factor is used to weight the amount of energy.

17. Device for determining a state of energy of an accumulator, including hardware and software means configured for implementing the method according to one of Claims 1 to 16.

18. Computer-readable data recording medium, whereon a computer program is recorded including computer program code means executable by the hardware means of the device according to Claim 17 for implementing the method according to Claims 1 to 16.

19. Computer program including a computer program code means executable by the hardware means of the device according to Claim 17 for implementing the method according to one of Claims 1 to 16.

Figure 1

-20°C                0°C                25°C

Z

Figure 2

Mesure $T_m$ et $P_m$ — E1

↓

E2 — Déterminer SOE[0]

↓

Evaluer Eni — E3

↓

E4 — Déterminer Enf

↓

E5 — Déterminer SOEf

Figure 3

E3-1 — Déterminer $En_{T1}$ et $En_{T2}$

↓

E3-2 — Interpolation -> Eni

Figure 4

Choisir points intermédiaires — E3-1-1

↓

E3-1-2 — Définir une équation de plan passant par les points choisis

↓

E5 — Déterminer $En_{Tj}$

Figure 5

E5-1 — Déterminer $SOE_{1\text{-}T1}$ et $SOE_{2\text{-}T2}$

E5-2 — Interpolation -> SOEf

Figure 6

E5-1-1 — Déterminer un ensemble de couple

E5-1-2 — Choisir le meilleur couple parmi l'ensemble

Figure 7

Figure 8

Figure 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   FR 2947637